# EUROPEAN PATENT SPECIFICATION

(11) **EP 3 257 054 B1**
(45) Date of publication and mention of the grant of the patent: **16.10.2019**
(21) Application number: 15705941.1
(22) Date of filing: 10.02.2015
(51) Int. Cl.: G21K 1/06, G03F 7/20

(54) **EUV MULTILAYER MIRROR, OPTICAL SYSTEM INCLUDING A MULTILAYER MIRROR AND METHOD OF MANUFACTURING A MULTILAYER MIRROR**
MEHRSCHICHTIGER EUV-SPIEGEL, OPTISCHES SYSTEM MIT EINEM MEHRSCHICHTIGEN SPIEGEL UND VERFAHREN ZUR HERSTELLUNG EINES MEHRSCHICHTIGEN SPIEGELS
MIROIR MULTICOUCHE À EUV, SYSTÈME OPTIQUE COMPRENANT UN MIROIR MULTICOUCHE ET PROCÉDÉ DE FABRICATION D'UN MIROIR MULTICOUCHE

(43) Date of publication of application: 20.12.2017
(73) Proprietor: Carl Zeiss SMT GmbH, 73447 Oberkochen (DE)
(72) Inventor: HUANG, Qiushi, Shanghai 200092 (CN); LOUIS, Eric, NL-3402 ZH IJsselstein (NL); BIJKERK, Frederik, NL-3735 LW Bosch en Duin (NL); DE BOER, Meint Jelle, NL-7513 ZD Enschede (NL); VON BLANCKENHAGEN, Gisela, 73433 Aalen (DE)
(74) Representative: Patentanwälte Ruff, Wilhelm, Beier, Dauster & Partner mbB
(86) International application number: PCT/EP2015/052767
(87) International publication number: WO 2016/128029

(56) References cited:
- US-A1- 2011 123 777
- HERPEN VAN M M J W ET AL: "Spectral-purity-enhancing layer for multilayer mirrors", OPTICS LETTERS, vol. 33, no. 6, 15 March 2008 (2008-03-15) , pages 560-562, XP001511939, ISSN: 0146-9592, DOI: 10.1364/OL.33.000560
- TAKEHARU OKUNO: "Development of subwavelength structure coating (SWC) and its application to imaging lenses", PROCEEDINGS OF SPIE, vol. 7652, 1 September 2010 (2010-09-01), pages 765203-765203-8, XP055216852, ISSN: 0277-786X, DOI: 10.1117/12.868985
- QIAOYIN YANG ET AL: "Antireflection effects at nanostructured material interfaces and the suppression of thin-film interference", NANOTECHNOLOGY, vol. 24, no. 23, 15 May 2013 (2013-05-15), page 235202, XP020245352, BRISTOL, GB ISSN: 0957-4484, DOI: 10.1088/0957-4484/24/23/235202

## Description

### BACKGROUND

The invention relates to a multilayer mirror for reflecting extreme ultraviolet (EUV) radiation and to optical systems comprising at least one such mirror. The invention further relates to a method of manufacturing a multilayer mirror.

Optical systems employed in the field of EUV lithography, such as illumination systems and projection systems in a EUV lithography apparatus, require reflective optical elements providing relatively high reflectivity for electromagnetic radiation from the extreme ultraviolet (EUV) wavelength range. The EUV wavelength range includes wavelengths between about 5 nm and 20 nm, for example. The lower end of this wavelength range is sometimes also denoted as beyond EUV (BEUV) or soft X-ray range. The optical elements employed in a EUV lithography system include curved or plane mirrors, reflective photo masks and other reflective elements capable of guiding or structuring EUV radiation. Reflective optical elements are also needed in optical inspection systems used to inspect photomasks or other patterning means using EUV radiation, or in EUV microscopes.

Any material used to reflect radiation in the EUV or soft x-ray range reflects only a few percent of incident radiation because the real part of the refractive index is close to unity. The complex refractive index n of a material may be described as a sum of the real part (1-δ) and the imaginary part iβ of the refractive index in accordance with n = (1-δ) + iβ. In this notation, the dimensionless parameter 8 describes the deviation of the real part of the refractive index n from the value 1 and may be denoted as "refractive index decrement". The dimensionless parameter β represents the extinction coefficient k. Differences in the real part of the refractive index at an interface between adjacent materials govern the contribution to reflectivity of the interface. Those differences (Δδ) are sometimes referred to as "refractive index contrast". The magnitude of the extinction coefficient is indicative of the amount of absorption of EUV radiation in a material and includes scattering properties on atomic level.

Due to the fact that only small differences in the real part of refractive index exist in the EUV or soft X-ray range, a reflective optical element operating at normal incidence or near normal incidence of EUV radiation must be designed as a multilayer mirror in order to be capable of reflecting EUV radiation with reasonably high reflectivity. In this application, the term "multilayer mirror" generally refers to any reflective optical element having multiple material layers effective to reflect EUV or soft X-ray radiation.

A multilayer mirror may be described as comprising a substrate and a stack of layers formed on the substrate, wherein the stack of layers comprises layers comprising a "low index material" and "high index material", the low index material having a lower real part of the refractive index than the high index material at a given operating wavelength λ in the EUV range. The material having a relatively lower real part of the refractive index at the operating wavelength (i.e. the low index material) is commonly denoted by the capital letter "L", while the material having a relatively higher real part of the refractive index (i.e. the high index material) at the operating wavelength is commonly denoted by the capital letter "H".

Multilayer mirrors typically include a plurality of repetitive units stacked upon each other in a recurring sequence. A repetitive unit including a single low index material layer and a single adjacent high index material layer may be referred to as "bilayer" or two-layer repetitive unit. A repetitive unit may include one or more additional layers, for example a diffusion barrier interlayer interposed between a low index material layer and a high index material layer to reduce intermixing of the adjacent materials at the interface. A sequence of repetitive units in a multi-layer mirror forms a stack of layers which essentially simulates the lattice planes of a crystal partially reflecting the incident radiation at interfaces between adjacent layers. The thicknesses of the individual layers as well as the total thickness of the repetitive units can be constant across the entire multilayer system, or they can vary laterally and/or in depth depending on which reflection profile is to be achieved. An optimum thickness of a repetitive unit may be calculated for a given wavelength and a given range of angles of incidence using Bragg's law, according to the crystal lattice plane model explained above.

The EUV light source is one of the biggest challenges for high volume EUV lithography. Plasma based light sources, including both laser produced plasma (LPP) and discharge produced plasma (DPP) have been used. A major requirement for these sources is to generate as high as possible clean EUV power for the exposure. Both plasma sources emit the in-band 13.5 nm light desirable for exposure. However, they also generate a considerable amount of so called out-of-band (OoB) radiation, especially in the UV range, typically from 100 nm to 400 nm. Moreover, multilayer mirrors for EUV optical system can be highly reflective for the UV light, which can result in UV exposure of the wafer and may cause image contrast loss.

Several spectral purity methods have been developed to filter out the UV light, including blazed gratings (see e.g. US 2002097385 A1), phase shift gratings (PSG) (see e.g. US 6522465 B1), anti-reflection layers (see e.g. US 2006245057 A1) and free-standing membranes (see e.g. US 2012147350 A1). However, the blazed grating has not yet achieved high EUV efficiency at normal incidence, PSG and AR layer have a limited suppression band and it is more difficult to develop an AR layer for the long wavelength part of the UV range. Membranes are fragile in application and may still absorb a significant amount of the EUV power.

Document WO 2012/119672 A1 discloses spectral purity filters designed as a grating spectral purity filter, comprising a multilayer stack of alternating layers, configured to reflect radiation of a first wavelength in a first direction relative to the multilayer stack; and a plurality of recesses in a top side of the multilayer stack, the recesses configured to form a grating arranged such that radiation of a second wavelength is reflected in a second direction relative to the multilayer stack that is different from the first direction.

Document EP 1 530 222 A1 describes an optical element for use with EUV radiation with a top layer which is transmissive for EUV radiation with wavelength in the range of 5-20 nm, and wherein the structure of the top layer is a structure having a rms roughness value equal to or larger than a tenth of the EUV radiation for spatial periods equal to or smaller than one half of the wavelength of the EUV radiation. Such a structure promotes EUV transmission through the top layer to the optical element.

Document DE 10 2009 044 462 A1 discloses an optical element having a multilayer structure, designed for reflecting electromagnetic radiation in the extreme ultraviolet wavelength range. The optical element has a lattice structure designed for deflecting electromagnetic radiation in the visible to infrared wavelength range and effective to change the relative intensities and/or the propagation directions of radiation from the ultraviolet radiation range.

Document US 2006/0245057 A1 discloses a multilayer mirror including on top of the multilayer mirror a spectral purity enhancement layer, for example for application in an EUV lithographic apparatus. This spectral purity enhancement layer includes a first spectral purity enhancement layer, but between the multi-layer mirror and first spectral purity enhancement layer there may optionally be an intermediate layer or a second spectral purity enhancement layer and intermediate layer. The spectral purity of normal incidence radiation may be enhanced, such that DUV radiation is diminished relatively stronger than EUV radiation.

The article by M.M.J.W. Van Herpen et al. :"Spectral-purity-enhancing layer for multilayer mirrors", Optics Letters vol. 33, no. 6 (2008) pages 560 - 562 demonstrates, both theoretically and experimentally, that special spectral-purity-enhancing multilayer mirror systems can be designed and fabricated to substantially reduce the level of out-of-band radiation expected in an extreme ultraviolet lithographic tool. A first proof of principle of applying such spectral-purity enhancement layers showed reduced out-of-band reflectance by a factor of five, while the in-band reflectance is only 4.5% (absolute) less than for a standard capped multilayer.

The article by T. Okuno: "Development of Subwavelength Structure Coating (SWC) and its Application to Imaging Lenses" in: Proc. SPIE, vol. 7652 (2010) pages 765203 - 765203-8 mentions that Canon Inc. released the new EF 24mm f/1.4L II USM lens with a subwavelength structure coating (SWC), a new type of high performance anti-reflective coating, in December 2008. The subwavelength structure, which is made from microcrystalline alumina, can be formed on large, curved surfaces using a simple sol-gel process. Furthermore, by inserting a thin-film layer with an intermediate refractive index between the lens and the microcrystalline alumina, it is possible to achieve superior anti-reflection performance matching various lens refractive indexes. The article presents the principles and performance of SWC and describes the application of SWC to imaging lenses.

### SUMMARY OF THE INVENTION

It is an object of the present invention to provide EUV multilayer mirrors including means capable of effectively suppressing undesirable radiation in the UV range while at the same time there is no or only little loss of EUV radiation caused by that means.

As a solution to these and other objects, the invention, according to one formulation, provides a multilayer mirror according to claim 1 and an EUV optical system according to claim 12. Preferred embodiments are given in the dependent claims. The wording of all the claims is incorporated into the description by reference.

A multilayer mirror according to this formulation includes a spectral purity filter on top of the stack of layers, i.e. on a radiation entry side of the stack of layers opposite to the substrate side. The spectral purity filter is designed to be effective as an anti-reflection layer for ultraviolet (UV) radiation from a second wavelength range in an UV spectral region in such a way that a EUV-UV-reflectivity ratio of the multilayer mirror is increased with respect to the same multilayer mirror having no such spectral purity filter layer. In a preferred situation, reflectivity for UV radiation will be significantly reduced, while reflectivity for EUV radiation (from the first wavelength range) will not be reduced or will be reduced only to a smaller extent. In some cases, UV reflectivity will be reduced stronger than EUV reflectivity so that the EUV-UV-reflectivity ratio is effectively increased. The spectral purity filter comprises a non-diffracting graded-index anti-reflection layer effective to reduce reflectivity in the second wavelength range. At the same time, the graded-index anti-reflection layer should have low absorption for EUV radiation (i.e. radiation from the first wavelength range).

For the purpose of this application, a graded-index anti-reflection layer is a layer formed of one single material or a combination of two or more different materials providing from a first medium on the radiation incidence side (incident medium) to a second medium on an exit side (substrate-side medium) a continuous or monotonous transition of effective refractive index from a refractive index value near the refractive index of the first medium to a refractive index value near to or at the refractive index of the second medium. A gradient effective index is thereby obtained. If a transition of effective refractive index is made gradual and the depth of transition extends over a significant fraction of the target wavelength (wavelength which is intended to be suppressed in reflectivity), reflection of the target wavelength may be suppressed efficiently.

The structure is made in a controlled way so that a reflection reducing effect is obtained for radiation in the second wavelength range, where wavelengths are significantly larger than in the first wavelength range. It is not desirable for a reflection reducing effect to be obtained for shorter wavelengths in the first wavelength range. Preferably, the structure is made so that no reflection reducing effect is obtained for wavelengths in the first wavelength range. A reflection enhancing effect may be possible for wavelengths in the first wavelength range, thereby supplementing the mirror function.

The graded-index anti-reflection layer is non-diffracting, which means that the graded-index layer is configured such that substantially no relevant intensity of radiation from the undesired out-of-band wavelength range (second wavelength range) is redirected by diffraction phenomenon. For example, if there is diffracted intensity in the second wavelength range at all, then the amount of residual intensity potentially diffracted by the graded-index anti-reflection layer could be less than 10% or less than 5% of the incident intensity in the second wavelength range (e.g. from 100 nm to 400 nm). Instead, enhanced transmission of the out-of-band wavelengths can be obtained so that the undesired radiation can be absorbed within the multilayer mirror. Therefore, no additional measures have to be provided to capture and absorb undesired radiation redirected from the mirror by diffraction.

The graded-index anti-reflection layer is an integral part of the multilayer mirror, as it is supported by the substrate and the stack of layers. The claimed invention integrates efficient means for suppressing UV reflection on the surface side of the multilayer mirror, preferably in order to suppress the full band of UV reflection under the premise of maintaining as high as possible EUV reflectivity.

A lower limit of the second wavelength range may be multiples of the upper limit of the first wavelength range.The first wavelength range may be from 5 nm to 20 nm so that the operating wavelength λ may be 13.5 nm, for example. On the other hand, the second wavelength range may extend from 100 nm to 400 nm, for example, so that it may include wavelengths from the deep ultraviolet (DUV) range (wavelengths less than about 300 nm) and the vacuum ultraviolet range (VUV) with wavelengths less than about 200 nm.

The graded-index anti-reflection layer comprises a sub-wavelength structure (SWS) comprising structural elements on a spatial (lateral) scale with lateral dimensions smaller than the UV wavelength in the second wavelength range. The sub-wavelength structure (SWS) is configured such that it is effective for the ultraviolet radiation in the second wavelength range as an effective medium with graded refractive index, capable of reducing an optical contrast at a radiation entry surface of the stack of layers and supress at least partly the ultraviolet radiation reflection. A gradient effective index resulting from a sub-wavelength structure can have a very broad anti-reflection band to cover the whole undesirable UV range so that the spectral purity of a EUV system can be highly improved.

The scale (the dimensions) of the structural elements in lateral direction is substantially smaller than the wavelength of radiation to be suppressed (in the second wavelength range). The scale may be smaller than half of the undesirable wavelength. Therefore, radiation from the second wavelength range cannot resolve the sub-wavelength structure, but "sees" the structure effectively as a composite material. On the other hand, the scale may be about equal or larger than the upper limit of the first wavelength range.

The sub-wavelength structure may be a structure comprising an array of structural elements with monotonically changing effective refractive index for any particular wavelength in the second wavelength range from a substrate side to a radiation incidence side (radiation entry side). In other words: an effective refractive index of the sub-wavelength structure with respect to a wavelength from the second wavelength range can increase monotonically from the radiation entry side to the substrate side (where the stack of layers is situated). A gradual index matching is thereby obtained.

According to the claimed invention, the sub-wavelength structure (SWS) is a periodic structure comprising an array of tapered structural elements forming a periodic surface relief structure.

Tapered structured elements typically have a narrow tip portion on the radiation entry side and a broader base portion. A transition in width between the tip portion and base portion may be continuous or step-like. The filling ratio provided by the plurality of structural elements (ratio between portions filled with material of the structural elements and portions without such material between the filled portions, in a plane perpendicular to the layer stack normal) will be low in the tip level (on the radiation entry side) and significantly higher on the base level. The optical properties of the sub-wavelength structure, for example the effective optical constants, are between the optical constants of air or vacuum (medium on the incidence side) and the optical constants of the material or materials used to form the structural elements and can be controlled by changing the filling ratio of the structure.

In some embodiments, the sub-wavelength structure comprises a pyramid-array surface relief structure. As an alternative, conical structural elements or Klopfenstein tapered structural elements may be generated.

Different types of structural elements (difference in shapes and/or dimensions) may be combined (e.g. areas with different shapes and/or dimensions on different laterally offset surface portions and/or on alternating surface portions). For example, the whole sub-wavelength structure on the surface may not need to have a same periodic structure. At different UV wavelength, the refractive index of the multilayer (substrate) is different. This may require different optimum graded index profiles to be provided, especially different tapered structures. A sub-wavelength structure comprising two or three or more different profile tapered structures may give even better UV suppression at some wavelength in the second wavelength range.

A sub-wavelength structure design on the surface may also have two or three different profiles, for example half of the surface comprising a first profile, and another half of the surface is a different (second) profile. In other words: the sub-wavelength structure may be a periodic structure comprising an array of tapered structural elements forming a periodic surface relief structure having a single periodicity (only one type of tapered structures) across the entire reflective surface or a combined periodic structure where two or three or more different profile tapered structures are combined. A single type of tapered structures over the entire reflective surface may be preferable, for example from a manufacturing point of view.

In order to provide efficient improvement of the EUV-UV-reflectivity ratio, a period length of the periodic structure in certain embodiments is larger than a wavelength in the first wavelength range and smaller than the wavelength in the second wavelength range. The period length is determined between corresponding portions of neighboring structural elements defined in the surface in which the layer extends.

Preferably, the period length of the sub-wavelength structure should be so small that no other diffraction orders except for the 0^{th} order exist for the second wavelength range. The period length should be smaller than the lower limit of the (out-of-band) second wavelength λ₂ of interest, and preferably smaller than λ₂/N (N≈2), in order to get higher suppression. The value of "N" depends on the "substrate" index (e.g. defined by an effective refractive index of the stack of layers reflecting in the EUV spectral region) and angles of incidence, for example. According to the claimed invention, the period length of the periodic structure is in a range from 25 nm to 100 nm.

The suppression effect is also dependent on the height of the structure, which may be adapted accordingly. In some embodiments, a structural depth of the sub-wavelength structure is smaller than the smallest wavelength in the second wavelength range and can be larger than wavelengths of the first wavelength range. In general, the structural depth should extend to a significant fraction of the wavelength to be suppressed, preferably at least λ₂/4, preferably more than λ₂/2, where λ₂ in this context represents the lower limit of the second wavelength range. If the structural depth deviates significantly from these values then evanescent diffraction modes may interfere with the 0^{th} order. For example, the structural depth may be in the order of 80 nm or smaller, or in the order of 50 nm or smaller. In general, the lower limit should be related to how much suppression is demanded. For example, with a period of 50 nm, pyramid shape, a depth of 60 nm will suppress the whole band reflectivity from 100 nm to 400 nm below 22%. On the other hand, given to the EUV absorption, depth values larger than 100nm, although possible, are presently considered less favorable.

An effective filter range can be influenced by appropriate combination of period length and structure depth. In a maximum filter range of a certain in sub-wavelength structure (purely considered from an index matching point of view) the longer wavelength side is predominantly affected by the structure depth, and the shorter wavelength side is predominantly affected by the structure period.

One advantage of sub-wavelength structures with periodic structures is that they can be manufactured in a targeted manner using established surface structuring methods, for example lithographic structuring techniques such as e-beam lithography, nano-imprint or interference lithography. Further, when compared to random structures, a periodic structure can have benefits as the distribution of random spatial frequencies can deteriorate the suppression if some structure period is larger than the wavelength and cause diffraction. In general, providing periodic structures allows controlling the suppression effects more accurately than by utilizing random structures.

On the other hand, a periodic structure is not generally necessary. The sub-wavelength structure may be formed by a structure having a random roughness with average dimensions in the lateral direction and depth direction corresponding to the dimensions mentioned for periodic structures. If a random structure is used, the average dimensions of the random structure should be greater than the upper limit of the first wavelength range.

A sub-wavelength structure may be a two dimensional (2D) structure on the surface, for example comprising pyramidal structure elements arranged in a two dimensional array. A one dimensional sub-wavelength structure, such as one dimensional non-diffracting grating of suitable grating constant, may also provide a suppression effect but only works for one polarization. Nevertheless, if the radiation source is polarized and radiation is incident from a fixed angle, a one dimensional (1D) sub-wavelength structure may be useful.

In some embodiments the graded-index anti-reflection layer, particularly in the form of a sub-wavelength structure (SWS), is formed of a single material having a low absorption for EUV radiation in the first wavelength range. The material can be selected from a group of materials having low absorption with extinction coefficient k less than 0.007, preferably 0.005 or less, at the first wavelength, for example.

The single material may be selected from materials not used for forming the layers of the stack of layers. However, a material used in composing the stack of layers may also be used.

In some embodiments, the single material is selected from the group consisting of amorphous silicon (Si), hydrogenated silicon (α-Si:H), and carbon (C). When selecting the appropriate material, the absorption edges of Si at A=12.4 nm or of carbon at λ=4.4 should be considered. The single material may be formed on a stack of layers after the stack of layers has been formed on the substrate.

In other embodiments, the graded-index anti-reflection layer comprises a multilayer structure corresponding to the multilayer structure of the stack of layers. When a sub-wavelength structure is used to form the graded-index anti-reflection layer, the structural elements can have the corresponding multilayer structure. In these embodiments, no additional material (in addition to the materials forming the layers of the stack of layers) is necessary to provide the graded-index anti-reflection layer.

The graded-index anti-reflection layer can be formed by targeted material removal from the surface after the multilayer structure including the stack of layers is formed. In these embodiments, the structural elements of the sub-wavelength structure (for example with pyramidal shape) may contribute to reflecting EUV radiation due to their multilayered structure so that an even higher EUV-UV-reflectivity ratio may be obtained. In this case the sub-wavelength multilayer pyramid structure (or other shape) may provide an even higher EUV efficiency, as the sub-wavelength structure itself is also reflective for EUV radiation.

In some embodiments a protective capping layer may be formed on the graded-index anti-reflection layer. A capping layer can be optimized and coated on the graded-index anti-reflection layer (such as the sub-wavelength structure) to protect the multilayer mirror against EUV plasma etching and/or cleaning methods, for example. The capping layer may include a material selected from the group consisting of BN, B₄C, B, C (e.g. diamond-like carbon), TiN, Pd, Rh, Ru, Au, C₂F₄, Si₃N₄, SiC, MgF₂ and LiF with an appropriate layer thickness. The layer thickness of the capping layer may be between 0.5 nm and 5.0 nm, for example.

It is possible to form the graded-index anti-reflection layer on a smooth surface of a multilayer structure. Alternatively the graded-index anti-reflection layer may be formed on a structured surface, i.e. a surface having a non-smooth relief structure. In some embodiments the graded-index anti-reflection layer is arranged and formed on a diffractive grating structure dimensioned to diffract radiation from a third wavelength range with wavelengths larger than the second wavelength

There is a possibility to integrate embodiments of the claimed invention with an IR (infrared) suppression method. A sub-wavelength structure may have a scale size of the period ≤ 100nm, and height in the range from 50 nm to 100 nm, for example. This antireflection surface (effective for UV radiation) can be applied on diffraction optics used for IR suppression, like a phase shift grating (PsG). Thus, a SWS+PsG+ML system can filter out both UV and IR light and finally achieve a clean EUV spectrum. Both single material and multilayer sub-wavelength structures can be applied.

In a method of manufacturing a multilayer mirror it is possible to form the spectral purity filter using a deposition technique capable of depositing the desired structure for the graded-index anti-reflection layer so that no further process steps are necessary after the deposition. However, in most embodiments one or more materials intended to later form the graded-index anti-reflection layer are first deposited on the stack of layers and material is partly removed thereafter from the free surface of the multilayer mirror in a structured fashion (in lateral and depth direction) so that a desired structure is obtained.

A conventional method (or method combination) known for structuring a multilayer mirror into a structured multilayer, such as a multilayer grating, a zone plate, a hologram or the like may be used for this purpose. Chemical methods, such as wet etching, or reactive ion etching (RIE) based on fluorine or chlorine have been proposed to fulfill these purposes.

Inventors have observed that conventional methods may generate structured multilayer mirrors suffering from large amounts of EUV loss after processing. It was found desirable to provide a process for structuring multilayer mirrors with no or only little damage caused in the remaining structure. The method could also be used for refurbishing multilayer mirrors. Such a method could be used in the process steps forming a graded-index anti-reflection layer in the embodiments of the present invention. The method might also be useful in other applications independent of the invention presently claimed.

The method includes the step of removing material from a free surface of the multilayer mirror by guiding an ion beam essentially consisting of noble gas ions having energies in the prescribed energy range onto target portions on the free surface of the multilayer.

Ion polishing using noble gas species like neon (Ne), argon (Ar), krypton (Kr) or xenon (Xe) with relatively low ion energies has been widely investigated and applied for layer growth assistance in depositing methods (for example in ion beam assisted deposition (IBAD or IAD). However, it is now proposed to utilize an ion beam essentially consisting of noble gas ions, with ion energies that usually are significantly higher than those used for the IBAD techniques, at least sufficiently high for the purpose of structuring a surface of a multilayer mirror and/or for refurbishing optical elements, particularly those with multilayer structure, by removing contaminants from a free (upper) surface.

Where an ion beam essentially consisting of noble gas ions is used in a material removal step performed on a free surface of a multilayer mirror, some disadvantages of using ion beams including chemically reactive gas species can be avoided. A reflective multilayer mirror structure composition includes layers of different materials stacked upon each other. If such layered structure is processed using reactive ion etching, there is a danger that holes and larger roughness may be generated by the etching process. It is believed that this is partly due to the fact that fluorine or chlorine based radicals or ions will usually have very different etching rates for the different materials forming the layers of the layer stack, for example molybdenum (Mo) and silicon (Si) or other multicomponent system composed of materials having a large difference in atomic number. Exclusion of chemically reactive gas species, such as fluorine or chlorine based radicals or ions, from the ion beam can at least partly avoid problems associated with preferential etching of different layer materials. An ion beam essentially consisting of noble gas ions performs essentially pure physical sputtering (or etching), which essentially has a much smaller difference of etch rate between different materials than sputtering in the presence of chemically reactive gas species. Therefore, a rather uniform etching process with low roughness is possible. The method is therefore particularly adapted for removing material from a free surface of a multilayer mirror made of layers with different materials or material combinations.

One or more of the following process conditions may be utilized to optimize the properties of the resulting surface structure for a specific purpose.

In some embodiments, the noble gas ions are selected from a group consisting of argon ions, neon ions, krypton ions and xenon ions.

It may be preferable that material is removed from the free surface at relatively low ion energies. The ion energy may be in the energy range from 100eV to 500eV, for example. For roughness, both ion energy and incidence angle of ions may influence the results. Working with near normal incidence may be preferable. Observing the ion energy condition appears to promote very little intermixing of the surface layers and small roughness. The removal of material may be controlled such that after material is removed, a surface roughness of the free surface is less than 1 nm rms. Even smaller values in the range of 0.5 nm rms or less may be obtained.

A separate (independent) control of ion density/flux and ion energy is used in some embodiments to improve performance of the material removing step. The step of generating the ion beam therefore includes control of ion flux and independent control of ion energy. Independent control of these parameters allows large ion flux to be combined with low ion energy to obtain a certain etch rate/mask selectivity and low sub-surface damage. The term etch rate/mask selectivity refers to an etch rate ratio between the mask material and the functional material (to be structured).

In an embodiment of an apparatus noble gas ions are generated by an inductive coupled plasma source (ICP) and a capacitive coupled plasma (CCP) is used to direct generated ions as an ion beam towards the target portion. Ion density/flux may be controlled by setting appropriate ICP power. Ion energy may be separately controlled by setting appropriate CCP power.

The apparatus can be used for (i) fabrication of multilayer mirrors with structured surface and (ii) refurbishment of multilayer mirrors and (iii) removal of contamination from the multilayer surface, for example. In this context, the term refurbishment includes e.g. removing from the surface several bilayers of multilayer if they are oxidized or contaminated, or removing the whole stack of multilayer.

Active cooling of the processed multilayer mirror during the machining process (ion bombardment) may improve the results. In an embodiment the multilayer mirror is supported on a substrate holder and the substrate holder is cooled to a temperature less than 0 °C., Temperatures less than -10 °C and/or less than -15 °C and/or temperatures in the order near or at -20 °C may be useful, for example. Higher temperatures, such as up to +10°C, may be useful in other cases.

Further, in order to be able to define the resulting surface profile as precise as possible, ions are directed on the target portion substantially at normal incidence in some embodiments. The term "substantially at normal incidence" is intended to mean that a mean beam direction of the incident ion beam deviates from a normal incidence (perpendicular to the surface) by less than 20° or less than 10°.

Various techniques may be utilized to prepare a multilayer structure for making a graded-index anti-reflection layer in the form of a sub-wavelength structure by material removal. For example, in an embodiment ultraviolet interference lithography is used to expose a resist layer coated on the multilayer structure prior to ion bombardment. Such technique is known to standardly produce 100 nm sized features, for example for grating patterns. Interference in two mutually perpendicular directions (x- and y-directions) can be utilized to produce a pyramid pattern or another two-dimensional pattern with tapered structure elements. Although this technique enables structures with typical period length of 100 nm, a double patterning technique may be used in order to obtain even smaller features. For example, an additional ultraviolet interference lithography step may be used upon double patterning to generate 50 nm features which are more effective in suppressing ultraviolet radiation and/or infrared radiation.

As an alternative, EUV or x-ray interference lithography may be used to fabricate a mask which can be used to fabricate a sub-wavelength structures having even smaller feature sizes.

Alternatively, a modified form of nano-imprint lithography (NIL) may be used. In typical cases the stamp or the reticle need not be perfectly aligned from stamp area to stamp area because minor defects or misalignments in the printing process can be tolerated. Conventional NIL features are routinely feasible down to a range of 30 to 50 nm, which are entirely adequate for typical applications in the present invention.

The invention also relates to an optical system comprising at least one EUV mirror of the type described in greater detail above or below.

The optical system can be e.g. a projection optical system or an illumination system for a microlithography projection exposure apparatus operating with EUV radiation. The EUV mirror can have a planar mirror surface or a convexly or concavely curved mirror surface. In an illumination system and/or in a projection optical system, one or several or all EUV mirrors may be constructed as described here. EUV mirrors can also be used in other optical systems, e.g. in the field of microscopy.

These and further features emerge not only from the claims but also from the description and the drawings, wherein the individual features can be realized in each case by themselves or as a plurality in the form of sub-combinations in an embodiment of the invention and in other fields and can constitute advantageous and inherently protectable embodiments. Exemplary embodiments of the invention are illustrated in the drawings and are explained in greater detail below.

### BRIEF DESCRIPTION OF THE DRAWINGS

Fig. 1A shows a schematic vertical section through the layer structure of a multilayer arrangement in accordance with a first exemplary embodiment;
Fig. 1B shows a depths profile of refractive index for UV radiation in a transition region between the environment and the multilayer mirror;
Fig. 2 shows an embodiment comprising a sub-wavelength structure with pyramidal structural elements made of a single material with low absorption for EUV radiation;
Fig. 3 shows an embodiment comprising a sub-wavelength structure with pyramidal structural elements made of a sequence of high and low index refractive layers similar to the layers of a stack of layers on the substrate side thereof;
Fig. 4 shows a diagram illustrating the reflectance for ultraviolet radiation in the second wavelength range for various embodiments together with the same reflectance of a reference multilayer mirror without graded-index anti-reflection layer;
Fig. 5 shows a diagram illustrating the reflectance of multilayer mirrors in the EUV wavelength range in a comparative view for two embodiments and a reference multilayer mirror without graded-index anti-reflection layer;
Fig. 6 and Fig. 7 show schematically embodiments of multilayer mirrors having both structures suppressing reflection of UV radiation and structures redirecting IR radiation; and
Fig. 8 shows optical components of a EUV microlithography projection exposure apparatus in accordance with an embodiment.

### DETAILED DESCRIPTION OF THE PREFERRED EMBODIMENTS

Aspects of embodiments of the invention are explained below by way of example using a plurality of embodiments of EUV mirrors designed for an EUV operating wavelength of A = 13.5 nm and for angles of incidence AOI in the range 0° to 40°, i.e. normal incidence or near normal incidence. The angle of incidence (AOI) denotes the angle formed by a ray impinging on the mirror surface relative to the normal N to the surface of the mirror at point of incidence. Angle-of-incidence intervals within this range can occur, for example, in optical systems for EUV microlithography which operate with a high numerical aperture.

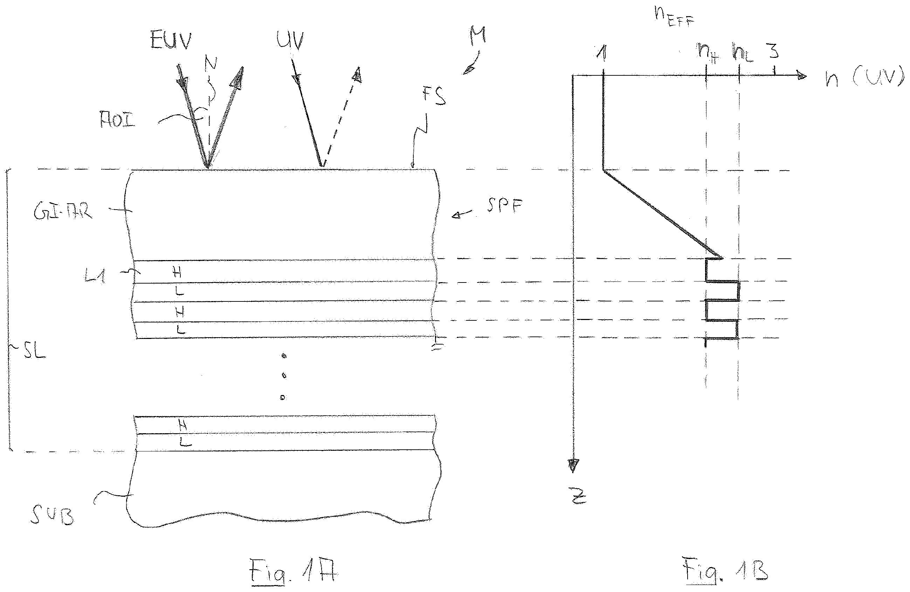

Figure 1 shows a schematic vertical section through the multilayer structure of an EUV mirror M according to a first embodiment. Mirror M comprises a substrate SUB and a stack of layers, SL, formed on the substrate. The stack of layers may also be denoted as "layer stack" SL. An outermost layer of the stack of layers, SL, terminates as the free surface FS of the multilayer mirror on the radiation incidence side. In operation, electromagnetic radiation including a predominant portion of EUV radiation is incident from vacuum on the mirror. In an optical system operating at a finite numerical aperture, rays of radiation enter the mirror from various angles of incidence.

The stack of layers is formed on the surface of the substrate SUB, which is machined to optical quality to exhibit the desired surface shape, which may be plane or curved. The single layers of the layer stack SL are then deposited on the substrate using a suitable deposition technique, such as Physical or Chemical Vapor Deposition (PVD or CVD). One or more additional layers may be formed on the surface of the substrate prior to depositing the layers of the layer stack, for example to improve mechanical stress properties on the substrate side of the stack of layers.

The stack of layers comprises layers made of a "low index material" (letter "L") and adjacent layers made of a "high index material" (letter "H") deposited on each other in alternate fashion. In a pair of adjacent layers, the low index material is the material having the lower real part of the refractive index at a given operating wavelength than the adjacent high index material. The layer material having a higher real part of the refractive index is also called "spacer" and the layer material having relative thereto a lower real part of the refractive index is also called "absorber". Layer pairs can be constructed e.g. with the layer material combinations molybdenum/silicon (Mo/Si) and/or ruthenium/silicon (Ru/Si). In this case, silicon respectively forms the spacer material, while Mo and/or Ru serve as absorber material.

The layer stack SL includes a large number of two-layer repetitive units each including a low index material layer and an adjacent high index material layer. Such repetitive units may also be referred to as "bilayer". A bilayer can contain at least one further layer, in particular an interposed barrier layer, which can consist e.g. of C, B₄C, SiₓN_{y}, SiC or a composition comprising one of said materials and is intended to prevent interdiffusion at the interface.

The layer structure of multilayer mirror M includes a spectral purity filter SPF on a radiation entry side of the stack of layers opposite to the substrate SUB. The free surface FS of the spectral purity filter forms the free surface of the multilayer mirror bounding to the environment, which is typically a vacuum in operation. The spectral purity filter is configured so that it is effective as an anti-reflection layer (AR layer) for ultraviolet radiation UV contained in the radiation incident on the multilayer mirror. While it is desirable that the multilayer mirror has high reflectivity for EUV radiation, the reflectivity of the portions of incident radiation in the UV range (typically from 100 nm to 400 nm) should be as small as possible to avoid significant amounts of UV radiation in the reflected radiation optically downstream of the mirror, i.e. after reflection on the mirror. The spectral purity filter SPF is effective to increase the EUV-UV-reflectivity ratio of the multilayer mirror when compared to a multilayer mirror having the same layer structure of the stack of layers, but without the spectral purity filter layer.

The spectral purity filter SPF of the embodiment comprises a non-diffracting graded-index anti-reflection layer GI-AR. The spectral purity filter may be formed entirely by the graded-index anti-reflection layer, but may also contain one or more additional layers. The graded-index anti-reflection layer GI-AR terminates as the free surface FS of the multilayer mirror.

Figure 1B shows a schematic diagram of a refractive index depth profile in the transition region between the environment (typically vacuum) and the layer structure of the multilayer mirror in a depth direction (z-direction, parallel to the surface normal N). The refractive index axis of the diagram refers to the effective refractive index, n_{EFF}, for radiation in the second wavelength range (UV radiation), particularly for DUV radiation. The effective refractive index on the radiation incidence side is typically at or very close to 1 (refractive index of vacuum). There may be a minor step towards relatively higher refractive index values (greater than 1) at the free surface FS, i.e. at the transition from a material free environment to a layer including solid layer material. In the example, a minor refractive index step is present between the graded-index antireflection layer GI-AR and the first continuous layer L1 of the stack of layers. The graded-index anti-reflection layer GI-AR has a distribution of material such that a gradient effective index for DUV radiation (in the second wavelength range) results, which forms a smooth, continuous transition from the refractive index nᵢ at the incidence side (at the free surface FS) to the refractive index of the outermost layer L1 of a repetitive unit on the substrate side of the graded-index anti-reflection layer (for example, layer L1 may be made of Si with n_{Si} = 2.56 at 300 nm). In the example there is a linear increase in refractive index from about 1 to values greater than 2. Within the bilayer structure of the stack of layers the refractive index alternates in a stepwise fashion between the value n_{H} of the high reflective index material H (corresponding to Si in the example) and the value n_{L} of the low reflective index material L (corresponding to Mo in this example, with n_{Mo} = 2.77 at 300 nm). (Note that the relative magnitudes of refractive index may have opposite relation in the DUV range. For example, in a Mo/Si combination, Si is the material with relatively lower refractive index in the DUV range)

A gradient-effective-index layer having these general characteristics can provide a very broad anti-reflection band (reflection-reducing characteristics) to suppress undesirable out-of-band (OoB) radiation especially in the UV range, typically at least in the range from 100 nm to 400 nm, for example.

The structure of the graded-index anti-reflection layer GI-AR is further configured such that virtually no diffraction of undesirable UV radiation is generated. Quite to the contrary, the graded-index anti-reflection layer GIL effectively enhances the transmission for UV radiation in the transition region so that large portions of the undesirable UV radiation can be absorbed within the depth of the layer structure of the multilayer mirror. A portion may be absorbed in the sub-wavelength structure.

Inventors have found that very efficient graded-index anti-reflection layers can be manufactured if the graded-index anti-reflection layer comprises or is formed by a sub-wavelength structure, which is further abbreviated by "SWS" in this application. The term "sub-wavelength structure" (SWS) as used herein denotes a structure having structural elements on a spatial (lateral) scale which is substantially smaller than the (undesirable) target wavelength, i.e. the wavelengths from the second wavelength range. If the typical dimensions are small enough in the lateral direction, then the UV radiation cannot resolve the fine structure, but "sees" the SWS as a composite material having a gradient of effective index between the incidence side and the substrate side. The optical properties of a sub-wavelength structure, e.g. the optical constants thereof, are typically between that of gas or vacuum on the one side and that of the material or materials used to generate the sub-wavelength structure. The optical properties can be controlled by changing the filling ratio of the structure, which will be explained in more detail below.

Periodic sub-wavelength structures may be preferable due to their potential for very efficient suppression of undesired radiation. Preferably, three conditions should be fulfilled so that a periodic structure may effectively work as a sub-wavelength structure approximating a continuous medium with an effective index. According to the first condition, a period-to-wavelength ratio should satisfy the condition P_{sws}/λ < 1/(max (nᵢ, nₛ) + nᵢ sin θ), where P_{sws} is the period length in the lateral direction, nᵢ is the refractive index on the radiation incidence side, nₛ is the refractive index on the substrate side of the sub-wavelength structure and λ is the target wavelength (second wavelength) and θ is the angle with respect to the normal of the surface of the multilayer structure. Secondly, it is preferable that the structure is designed such that only one non-evanescent mode is able to propagate in the structure. Thirdly, a structural depth of the sub-wavelength structure should be larger than a significant fraction of the wavelength of the undesirable UV radiation in the second wavelength range.

Some embodiments of the invention are characterized by the fact that a sub-wavelength structure effective as a graded-index anti-reflection layer is integrated on the light incidence surface side of an EUV-multilayer mirror. It is thereby possible to suppress large portions or the full band of undesirable UV reflection under the premise of maintaining a high level of EUV reflectivity.

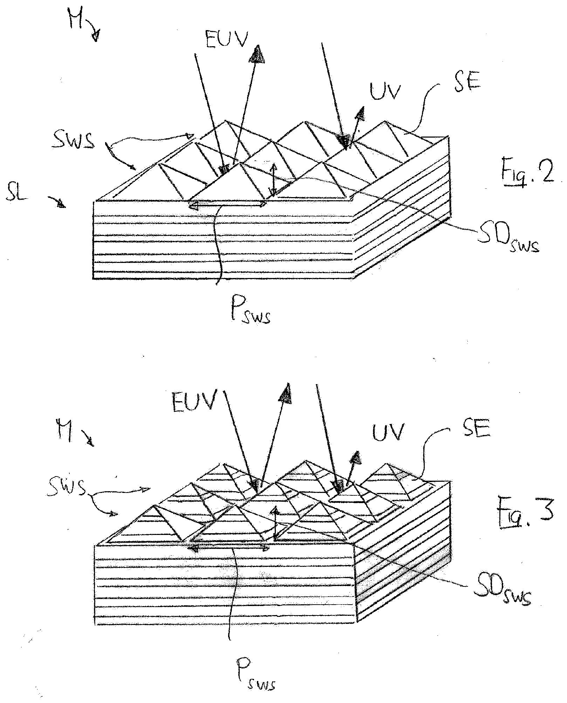

In some embodiments, the sub-wavelength structure SWS is made of a single material with low absorption for EUV radiation to reduce EUV loss. An embodiment is explained in detail in connection with Fig. 2. Other embodiments are characterized by the fact that the structural elements of the sub-wavelength structure are basically made from the same sequence of high and low index refractive layers as the stack of layers on the substrate side thereof. In that case the sub-wavelength structure may have a double effect because (i) EUV radiation may be reflected by the structural elements of the sub-wavelength structure and (ii) the structural elements will be effective to reduce reflectivity of the undesirable UV radiation. An embodiment is described in connection with Fig. 3.

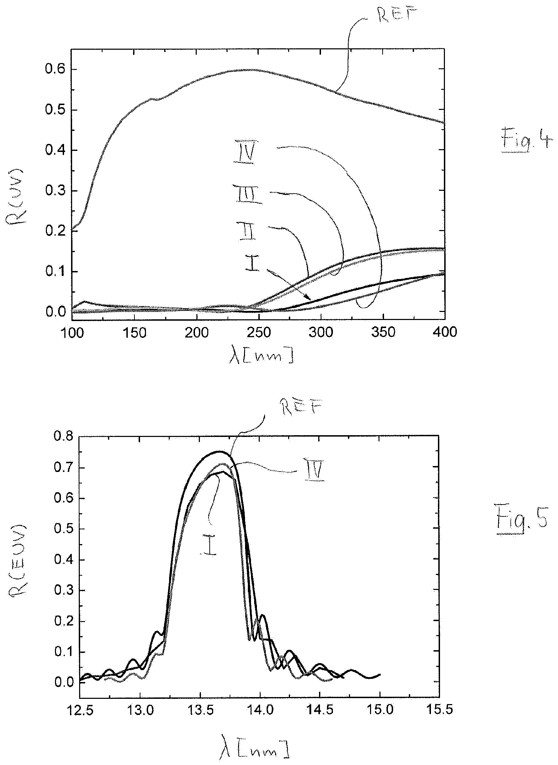

Fig. 4 shows a diagram illustrating the reflectance R (UV) for ultraviolet radiation in the wavelength range from 100 nm to 400 nm for various embodiments of the present invention together with the same reflectance of a reference multilayer mirror REF having a layer stack with Mo/Si multilayers without graded-index anti-reflection layer. Fig. 5 shows a diagram illustrating the reflectance R (EUV) of multilayer mirrors in the EUV wavelength range from 12.5 nm to 15.5 nm in a comparative view for two embodiments of the present invention and a reference Mo/Si multilayer mirror REF without graded-index anti-reflection layer.

In the embodiment of Fig. 2 the sub-wavelength structure SWS formed on the radiation entry side of the stack of layers SL is made of a single material with low absorption for EUV radiation. The EUV low-absorption material can be amorphous silicon, for example, due to the absorption edge of Si at λ=12.4 nm. A hydrogenated Si, α-Si:H, can be used as an alternative to obtain even less absorption.

Alternatively the single material can be amorphous carbon, which corresponds to a material that is often present or can build up during operation as a contamination layer on the free surfaces of EUV reflecting multilayers. In order to provide sufficient material for a subsequently formed sub-wavelength structure SWS, the carbon contamination layer can be made thicker by deliberately forcing the contamination in between operation periods, e.g. by providing a carbon containing contamination source and simultaneous irradiation with EUV light in the vicinity of the surface that shall be covered with a sub-wavelength structure SWS made of carbon. After this, a focused ion beam, e.g. with hydrogen ions may be directed towards the carbon layer in a patterning fashion, such that the desired sub-wavelength structure is forming in the carbon layer. According to this method, the geometry of the sub-wavelength structure SWS can be modified in situ, i.e. without removing the optical element carrying the sub-wavelength structure SWS from the optical system.

The sub-wavelength structure SWS comprises a regular 2D array of structural elements SE having a generally tapered form with a broad base on the substrate side and a tip on the radiation incidence side. The structural elements SE in the embodiment take the form of pyramids with quadratic base. The tapered shape causes a continuous increase in filling ratio from the radiation incidence side to the substrate side. As used here, the term "filling ratio" refers to a ratio between portions of an area filled with (solid) material and the entire area under consideration in a given sectional plane extending in lateral directions at a certain level (depth) through the sub-wavelength structure SWS. Evidently, the filling ratio is small at the tip level and larger on the base level of the pyramidal sub-wavelength structure. Filling ratio equals 1 in a solid layer of material.

The sub-wavelength structure SWS may be characterized by a period length P_{SWS} of (lateral distance between adjacent corresponding portions, for example lateral distance between directly adjacent grooves between pyramids) in the range of 100 nm to 50 nm, i.e. smaller than the (undesirable) second wavelength, but significantly larger than the (desirable) EUV radiation. A structural depth SD_{SWS} is measured in the normal direction of the multilayer mirror between the substrate side of the sub-wavelength structure (at the base portions of the pyramids) and the light incidence side (at the level of the pyramid tips). In the embodiment, the structural height is about 80 nm, which can already achieve high suppression in the full band of the EUV range. However, other values, such as between 50 nm and 100 nm for example, would also be possible.

For period lengths P_{SWS} = 50 nm and structural depths SD_{SWS} = 80 nm (curve I in Fig. 4 and Fig. 5) the pyramid-on-multilayer system shows an average UV suppression by about factor 19 compared to the Mo/Si reference system without sub-wavelength pyramid structure. The EUV reflectance is about 68.5% (compared to about 75% for the "perfect" Mo/Si-reference system).

Further, the structure shows a relative reflectance up to 91.3%, which is much higher than the relative reflectance of a free-standing membrane.

Curve II shows the reflectance of a Si pyramid SWS with P_{SWS} = 80 nm and SD_{SWS} = 80 nm.

It is worth to note that a protective capping layer can be added on top of the sub-wavelength structure. This may require further optimization regarding capping layer material and structural shape. As an example, curve III in Fig. 4 shows the UV reflectance of such sub-wavelength structure with P_{SWS} = 80 nm, SD_{SWS} = 80 nm and a 2 nm thick layer of SiO₂ capping layer on the surface thereof.

A sub-wavelength multilayer pyramid structure basically in accordance with Fig. 3 may provide an even higher EUV efficiency due to the fact that the structural elements SE of the sub-wavelength structure (here shaped as quadratic pyramids) are also reflective for EUV radiation due to their multilayer structure. Nevertheless, the lateral period length P_{sws} of the sub-wavelength structure required for UV suppression should be smaller than the UV wavelength to be suppressed but still larger than the EUV wavelength.

EUV diffraction is evident for multilayer pyramids with period from about 100nm towards smaller periods. But the diffraction angles of the higher orders are too large for sub-1 00nm period so the higher orders cannot be collected. Simulations show that when period is reduced from 80 nm to 30 nm, the 0th order efficiency/reflectance is increasing, so diffraction efficiency is decreasing. Further reducing the period will help to reduce the reflectivity loss due to high orders diffraction.

For instance, a multilayer sub-wavelength structure with a period length of 30 nm and a structural depth of 84 nm (corresponding to 12 bilayers, see curve IV in Fig. 4 and Fig. 5) can still have a high EUV reflectance (0^{th} order) of 71.1%, which means a relative efficiency of 94.8%. This value is even higher than the value discussed above for structural elements made of Si. The efficiency of the multilayer pyramid structure with regard to UV suppression is comparable to that of the single material Si pyramid sub-wavelength structure as shown in Fig. 4.

The reflectance values discussed here are based on calculations rather than measurements. All calculations were performed based on rigorous coupled wave theory (RCWT). Alternative shapes of structural elements, like tapered structures which can produce linear, cubic, quintic index profiles, or Klopfenstein tapered structures, can be used. With further optimization, they may provide better suppression effect which may then be sufficiently efficient with even less structural depth of the SWS to achieve the same suppression results as pyramid structures.

Pyramid structure here is a geometric profile, not an index profile. Different groove shapes may also be optimized for the multilayer sub-wavelength structure to further reduce undesirable diffraction effects for EUV radiation.

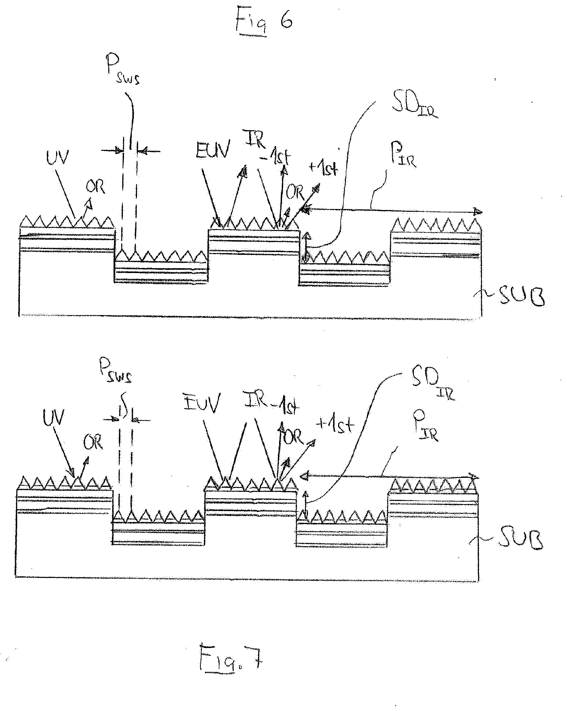

A sub-wavelength structure effective as a graded-index anti-reflection layer for UV radiation may be integrated with structures capable of suppressing infrared (IR) radiation from being reflected in 0^{th} order from a surface of a multilayer mirror. Exemplary embodiments of multilayer mirrors having both structures suppressing reflection of UV radiation and structures redirecting IR radiation are schematically shown in Fig. 6 and Fig. 7. Both a single material sub-wavelength structure basically in accordance with the embodiment of Fig. 2 (see Fig. 6) and a multi-layered sub-wavelength structure basically in accordance with the embodiment of Fig. 3 (see Fig. 7) may be applied. Characterizing features are now explained in connection with the embodiment of Fig. 6.

The multilayer mirror M in Fig. 6 comprises a substrate SUB and a stack of layers SL comprising alternative low index material and high index material layers are formed on the substrate. A spectral purity filter SPF comprising a 2D periodic pyramid structure made of silicon (Si) is formed on each portion of the stack of layers. Typical dimensions of the sub-wavelength structure may be the same as in the previous embodiments, for example with period lengths below 100 nm and typical structural depths in the order of 80 nm, for example.

This anti-reflection structure effective to suppress reflection of UV radiation is applied on a diffractive structure dimensioned to effectively suppress direct reflection of infrared radiation. Specifically, a 2D phase shift grating structure PSG is formed on the incidence side of the multilayer structure. In order to efficiently diffract incident IR radiation out of the optical path used for EUV radiation, a periodic grating structure is formed with lateral period lengths P_{IR} in the order of about 1 mm, for example (typically in a range from 100 µm to 1000 µm) and a structural depth SD_{IR} in the order of one fourth of the wavelength of infrared radiation.

The effect of the integrated structure on incident radiation including portions of extreme ultraviolet radiation (EUV), ultraviolet radiation (UV) and infrared radiation (IR) is schematically depicted by the arrows in Fig. 6 or Fig. 7. Incident EUV radiation is reflected with high reflectance by the multilayer structure of the stack of layers without being strongly influenced by either the coarse grating structure suppressing infrared radiation or the fine sub-wavelength structure having anti-reflective effect for UV radiation. Therefore, reflected intensity is a substantial portion of the incident intensity of EUV radiation. Reflection of UV radiation is efficiently suppressed by the pyramid-like sub-wavelength structure on the incidence side of the structured multilayer mirror substantially without diffracting any UV radiation in directions other than the 0^{th} order reflection direction. Further, portions of incident radiation from the IR range are effectively diffracted by the phase shift grating structure PSG with typical period lengths in the order of the wavelengths of the infrared radiation. Mainly due to diffraction, intensity of infrared radiation in the direction corresponding to the 0^{th} order (OR) of diffraction is substantially reduced, while a relatively larger portion of incident IR radiation is diffracted into 1^{st}, 2^{nd} and 3^{rd} etc. orders of diffraction. The phase shift grating lateral structure is dimensioned such that diffracted IR radiation is directed out of the optical path intended to be used by EUV radiation. IR intensity that is left in the 0^{th} order direction is further suppressed via destructive interference of the IR light, due to the phase shift grating vertical structure depth which corresponds to an optical path difference in the order of one fourth of the IR wavelength.

It is worthy to mention that structural elements of a sub-wavelength structure may have different shape like pyramid with four facets, or pyramid with a cone shape. Sometimes, the cone shape can give even better UV suppression.

Based on theoretical and experimental results, integrated structures of this type may provide a total EUV relative reflectance in the order of 81% or more when compared to a corresponding multilayer mirror structure without such spectral purity filter layer.

Embodiments of the invention including sub-wavelength graded-index anti-reflection layers effective to reduce reflectivity in the UV spectral range include the following advantages when compared to current spectral purity methods addressed in the introductory portion.

Firstly, a full band UV suppression can be obtained including the wavelength range from about 100 nm to 400 nm, which is considered an improvement when compared to the antireflection layer method based on destructive interference or phase shift grating

Further, there is only minor loss of EUV power. It has been found that an EUV relative reflectance after applying such surface structures is expected to be in the order of 91.3% to 94.8% normalized to a standard Mo/Si multilayer mirror without such structure. Thus, if an ideal multi-layer mirror including such sub-wavelength structure is used to replace a conventional multi-layer mirror not having such graded-index anti-reflection layer, it is expected that less than 9% to 5% EUV power will be lost, while at the same time the level of UV radiation intensity is significantly reduced.

Further, multilayer mirrors according to embodiments of the invention provide higher mechanical stability as compared to free-standing membranes.

Further, a better thermal stability can be expected when compared to thin films or membranes especially under high heat load.

A capping layer can be optimized and coated on the Si sub-wavelength structure in order to protect the multilayer structure against EUV plasma etching or cleaning methods.

The multilayer mirror may be a collector mirror collecting EUV radiation from a primary radiation source. The spectral purity filter comprising a non-diffracting graded-index anti-reflection layer to efficiently reduce UV reflected intensity can also be applied to any multilayer mirror utilized in an EUV exposure apparatus in order to suppress undesired wavelengths optically downstream of the collector mirror.

An embodiment of a method of manufacturing multilayer mirrors according to embodiments of the present invention includes a new physical patterning process to remove material from a free surface of the multilayer mirror by guiding an ion beam essentially consisting of noble gas ions having energies in a prescribed energy range onto target portions on the free surface of the multilayer mirror. An embodiment using argon (Ar) ions is described in detail.

In a first step, a reflective multilayer structure (multilayer composition) including a stack of layers comprising alternating high and low refractive index layers is fabricated in a conventional way. If a single material sub-wavelength structure is desired (see e.g. Fig. 2 and corresponding description) a thick layer of the single material (e.g. a 80 nm layer of Silicon) is formed in a final depositing step prior to structuring. A structuring process including targeted material removal is applied after the deposition is finished.

An inductively coupled plasma source (ICP) of argon is used to produce high ion density. A further source, namely a capacitive coupled plasma (CCP), is used in a pulsed mode to direct the ions from the coupled plasma source region towards the sample to be structured with low energy, suitable for targeted removal of layer material and therewith creating a structure according to an embodiment or the invention. The sample is placed in a fixed position on a sample holder. A cooling device is provided to cool the sample holder down to temperatures in the order of -20 °C during the process. A low working pressure (< 10 mTorr) (1 mTorr = 0.13 Pa) is applied to avoid collisions and to keep the directionality of ion flux. Preferably, the ions are impinged at normal incidence for this process.

Dual source systems basically suitable for performing the process are known per se so that no detailed description is given here. For example, dual source systems are known in the deep reactive ion etching field, which typically contains a ICP source and an CCP source. Such system can also work at non-reactive mode - using only ions to sputter material. Such mode can be utilized here. Details on dual source systems are described, for example, in: H. V. Jansen, M. J. de Boer et al, "Black silicon method X: a review on high speed and selective plasma etching of silicon with profile control: an in-depth comparison between Bosch and cryostat DRIE processes as a roadmap to next generation equipment", J. Micromech. Microeng. 19 (2009) 033001.

The dual source system provides for a largely separate control of ion density/flux (controlled by setting the ICP power) and ion energy (controlled by setting CCP power). Independent control of ion density/flux and ion energy allows for generating large ion flux with low ion energy to obtain a desired etch rate and/or mask selectivity and, at the same time, low level of sub-surface damage.

This process is pure physical sputtering, which essentially has a much smaller difference of etch rate between different materials than conventional methods, such as reactive ion etching (RIE), which utilize reactive chemically reactive gas species, such as fluorine or chlorine, to support the etching process. The process using noble gas ions is capable of producing relatively uniform etching with low roughness. The process can be applied to different multi-layered structures and/or material combinations.

The process may be particularly useful as a process for patterning multilayer structures and/or for refurbishing multilayer structures and/or removal of contamination from a mirror surface. In experiments, over 94% reflectance has been maintained relatively after patterning through 15 bilayers, and the surface roughness was still as low as about 0.2 nm rms.

The reflectance of the refurbished multilayer mirror whose surface layers are etched away can be further improved by matching the end etching position in the top period with a standing wave field. As the process is pure ion sputtering, the flux and energy uniformity is mainly determined by the bias field (capacitive coupled plasma) on the sample. Therefore, the process may achieve better etching uniformity over a large area compared to processes including chemical plasma with radicals. The etch rate can also be increased by increasing the ion flux.

The process is not limited to using Ar ions, but other noble gas ions, such as neon (Ne), krypton (Kr) or xenon (Xe) may be used. The process can also be applied to different multilayers or multi-component systems with more than one material composition.

Multilayer refurbishment is usually done after surface contamination by e.g. tin, Gd, Tb, carbon, oxides or combinations thereof. A non-flat topography may cause a roughness replication problem for physical sputter. Other chemical cleaning processes can be combined or applied before this physical etching process to improve the performance of the refurbishment.

EUV mirrors of the type described in this application can be used in various optical systems, e.g. in the field of EUV microlithography.

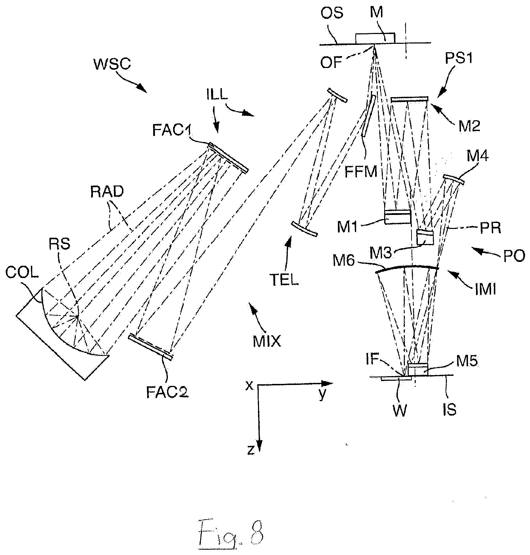

Figure 8 shows by way of example optical components of a EUV microlithography projection exposure apparatus WSC in accordance with one embodiment of the invention. The EUV microlithography projection exposure apparatus serves for the exposure of a radiation-sensitive substrate W arranged in the region of an image plane IS of a projection lens PO with at least one image of a pattern of a reflective patterning device or mask M, said pattern being arranged in the region of an object plane OS of the projection lens.

In order to facilitate the description, a Cartesian xyz coordinate system is indicated, which reveals the respective positional relationship of the components illustrated in the figures. The projection exposure apparatus WSC is of the scanner type. During the operation of the projection exposure apparatus, the mask M and the substrate are moved synchronously in the y-direction and thereby scanned.

The apparatus is operated with the radiation from a primary radiation source RS. An illumination system ILL serves for receiving the radiation from the primary radiation source and for shaping illumination radiation directed onto the pattern. The projection lens PO serves for imaging the structure of the pattern onto a light-sensitive substrate.

The primary radiation source RS can be, inter alia, a laser plasma source or a gas discharge source or a synchrotron-based radiation source. Such radiation sources generate a radiation RAD in the EUV range, in particular having wavelengths of between 5 nm and 15 nm. In order that the illumination system and the projection lens can operate in this wavelength range, they are constructed with components which are reflective to EUV radiation.

Radiation emerging from the radiation source typically contains portions of radiation having wavelength other than the desired EUV radiation, particularly UV radiation and infrared (IR) radiation.

The radiation RAD emerging from the radiation source RS is collected by means of a collector COL and guided into the illumination system ILL. The illumination system comprises a mixing unit MIX, a telescope optical unit TEL and a field forming mirror FFM. The illumination system shapes the radiation and thereby illuminates an illumination field situated in the object plane OS of the projection lens PO or in the vicinity thereof. In this case, the shape and size of the illumination field determine the shape and size of the effectively used object field OF in the object plane OS.

A reflective reticle or some other reflective patterning device is arranged in the object plane OS during the operation of the apparatus.

The mixing unit MIX substantially consists of two facet mirrors FAC1, FAC2. The first facet mirror FAC1 is arranged in a plane of the illumination system which is optically conjugate with respect to the object plane OS. Therefore, it is also designated as a field facet mirror. The second facet mirror FAC2 is arranged in a pupil plane of the illumination system that is optically conjugate with respect to a pupil plane of the projection lens. Therefore, it is also designated as a pupil facet mirror.

With the aid of the pupil facet mirror FAC2 and the imaging optical assembly which is disposed downstream in the beam path and which comprises the telescope optical unit TEL and the field forming mirror FFM operated with grazing incidence, the individual mirroring facets (individual mirrors) of the first facet mirror FAC1 are imaged into the object field.

The spatial (local) illumination intensity distribution at the field facet mirror FAC1 determines the local illumination intensity distribution in the object field. The spatial (local) illumination intensity distribution at the pupil facet mirror FAC2 determines the illumination angle intensity distribution in the object field.

The projection lens PO serves for the reducing imaging of the pattern arranged in the object plane OS of the projection lens into the image plane IS that is optically conjugate with respect to the object plane and lies parallel thereto. This imaging is effected by means of electromagnetic radiation from the extreme ultraviolet range (EUV) around an operating wavelength λ, which in the case of the example is 13.5 nm.

The projection lens has six mirrors M1 to M6 having mirror surfaces which are arranged in a projection beam path PR between the object plane OS and the image plane IS in such a way that a pattern arranged in the object plane or in the object field OF can be imaged into the image plane or the image field IF by means of the mirrors M1 to M6.

The mirrors (EUV mirrors) M1 to M6 having a reflective effect for radiation from the EUV range each have a substrate, on which is applied a multilayer arrangement having a reflective effect for radiation from the extreme ultraviolet range and comprising a large number of layer pairs comprising alternately relatively low refractive index and relatively high refractive index layer material.

Projection exposure apparatuses and projection lenses having this or a similar construction are disclosed for example in the patent US 7,977,651 B2.

In the illumination system ILL, with the exception of the field forming mirror FFM operated with grazing incidence, all mirrors can benefit from multilayer mirror structure of the type proposed here. Alternatively, or in addition, the reflective surface of the collector mirror COL may have structures reducing reflected intensity of UV radiation, in some cases in addition to structures diffracting IR radiation out of the path of EUV radiation.

## Claims

1. A multilayer mirror (M) reflecting extreme ultraviolet (EUV) radiation from a first wavelength range in a EUV spectral region, the mirror comprising:
a substrate (SUB);
a stack of layers (SL) on the substrate,
the stack of layers comprising layers comprising a low index material and a high index material, the low index material having a lower real part of the refractive index than the high index material at a given operating wavelength λ in the first wavelength range,
a spectral purity filter on top of the stack of layers, the spectral purity filter effective as an anti-reflection layer for ultraviolet (UV) radiation from a second wavelength range in a UV spectral region to increase a EUV-UV-reflectivity ratio of the multilayer mirror,
**characterized in that**
the spectral purity filter (SPF) comprises a non-diffracting graded-index anti-reflection layer (Gl-AR) effective to reduce reflectivity in the second wavelength range,
the non-diffractive graded-index anti-reflection layer (GI-AR) comprising a sub-wavelength structure (SWS) comprising structural elements (SE) with lateral dimensions smaller than the UV wavelength in the second wavelength range in such a way that the sub-wavelength structure (SWS) is effective for the ultraviolet radiation in the second wavelength range as an effective medium with graded refractive index, capable of reducing an optical contrast at a radiation entry surface of the stack of layers and suppress at least partly the ultraviolet radiation reflection,
wherein the sub-wavelength structure (SWS) is a periodic structure comprising an array of tapered structural elements (SE) forming a periodic surface relief structure,
a period length (PSWS) of the periodic sub-wavelength structure (SWS) being in a range from 25 nm to 100 nm.

2. The multilayer mirror according to claim 1, wherein the sub-wavelength structure (SWS) is a structure comprising an array of structural elements (SE) with monotonically changing effective refractive index in the second wavelength range from a substrate side to a radiation incidence side.

3. The multilayer mirror according to claim 1 or 2, wherein the sub-wavelength structure comprising an array of tapered structural elements forming a periodic surface relief structure has a single periodicity across the entire reflective surface or wherein the sub-wavelength structure is a combined periodic structure where two or more different profile tapered structures are combined on the entire reflective surface.

4. The multilayer mirror according to one of claims 1 to 3 wherein the sub-wavelength structure (SWS) comprises a pyramid-array surface relief structure.

5. The multilayer mirror according to one of claims 1 to 4, wherein a period length (P_{SWS}) of the periodic sub-wavelength structure (SWS) is larger than a wavelength in the first wavelength range and smaller than a wavelength in the second wavelength range.

6. The multilayer mirror according to one of claims 1 to 5, wherein a structural depth (SD_{SWS}) of the sub-wavelength structure (SWS) is smaller than the wavelength in the second wavelength range.

7. The multilayer mirror according to any one of the preceding claims, wherein the non-diffractive graded-index anti-reflection layer is formed of a single material having a low absorption with an extinction coefficient of less than 0.007 for EUV radiation in the first wavelength range, wherein the single material is selected from the group consisting of amorphous silicon (Si), hydrogenated silicon α-Si:H, and carbon (C).

8. The multilayer mirror according to any one of claims 1 to 6, wherein the non-diffractive graded-index anti-reflection layer comprises a multilayer structure corresponding to the multi-layer structure of the stack of layers

9. The multilayer mirror according to any one of the preceding claims, wherein a protective capping layer is formed on the non-diffractive graded-index anti-reflection layer.

10. The multilayer mirror according to any one of the preceding claims, wherein the non-diffractive graded-index anti-reflection layer is arranged on a diffractive grating structure dimensioned to diffract radiation from a third wavelength range with wavelengths larger than the second wavelength.

11. The multilayer mirror according to any one of the preceding claims, wherein the multi-layer mirror is a collector mirror (COL) for collecting EUV radiation emitted from an EUV radiation source.

12. A EUV optical system comprising at least one multilayer mirror according to one of claims 1 to 11.

## Patentansprüche

1. Mehrschichtspiegel (M), der Extremultraviolett(EUV)-Strahlung eines ersten Wellenlängenbereichs in einem EUV-Spektralgebiet reflektiert, wobei der Spiegel folgendes umfasst:
ein Substrat (SUB);
einen Stapel aus Schichten (SL) auf dem Substrat,
wobei der Stapel aus Schichten Schichten umfasst, die ein Material mit niedrigem Brechungsindex und ein Material mit hohem Brechungsindex umfassen, wobei das Material mit niedrigem Brechungsindex einen niedrigeren Realteil des Brechungsindex als das Material mit hohem Brechungsindex bei einer gegebenen Betriebswellenlänge λ in dem ersten Wellenlängenbereich aufweist,
einen spektralen Reinheitsfilter auf dem Stapel aus Schichten, wobei der spektrale Reinheitsfilter als eine Antireflexionsschicht für Ultraviolett(UV)-Strahlung eines zweiten Wellenlängenbereichs in einem UV-Spektralgebiet effektiv ist, um ein EUV-UV-Reflektivitätsverhältnis des Mehrschichtspiegels zu erhöhen,
**dadurch gekennzeichnet, dass**
der spektrale Reinheitsfilter (SPF) eine nicht beugende Antireflexionsschicht mit einem Brechungsindexgradienten (GI-AR) umfasst, die effektiv zum Reduzieren einer Reflektivität in dem zweiten Wellenlängenbereich ist,
wobei die nicht beugende Antireflexionsschicht mit Brechungsindexgradienten (GI-AR) eine Subwellenlängenstruktur (SWS) umfasst, die strukturelle Elemente (SE) mit lateralen Abmessungen kleiner als die UV-Wellenlänge in dem zweiten Wellenlängenbereich auf eine solche Weise umfasst, dass die Subwellenlängenstruktur (SWS) effektiv ist für die Ultraviolettstrahlung in dem zweiten Wellenlängenbereich als ein effektives Medium mit Brechungsindexgradienten, das zum Reduzieren eines optischen Kontrasts bei einer Strahlungseinfallsoberfläche des Stapels aus Schichten ist und die Ultraviolettstrahlungsreflexion wenigstens teilweise unterdrückt,
wobei die Subwellenlängenstruktur (SWS) eine periodische Struktur ist, die ein Array aus sich verjüngenden strukturellen Elementen (SE) umfasst, die eine periodische Oberflächenreliefstruktur bilden,
wobei eine Periodenlänge (PSWS) der periodischen Subwellenlängenstruktur (SWS) in einem Bereich von 25 nm bis 100 nm liegt.

2. Mehrschichtspiegel nach Anspruch 1, wobei die Subwellenlängenstruktur (SWS) eine Struktur ist, die ein Array aus strukturellen Elementen (SE) mit sich monoton änderndem effektiven Brechungsindex in dem zweiten Wellenlängenbereich von einer Substratseite zu einer Strahlungseinfallsseite umfasst.

3. Mehrschichtspiegel nach Anspruch 1 oder 2, wobei die Subwellenlängenstruktur, die ein Array aus sich verjüngenden strukturellen Elementen umfasst, die eine periodische Oberflächenreliefstruktur bilden, eine einzige Periodizität über die gesamte reflektierende Oberfläche hinweg aufweist oder wobei die Subwellenlängenstruktur eine kombinierte periodische Struktur ist, bei der zwei oder mehr sich verjüngende Strukturen mit unterschiedlichem Profil auf der gesamten reflektierenden Oberfläche kombiniert sind.

4. Mehrschichtspiegel nach einem der Ansprüche 1 bis 3, wobei die Subwellenlängenstruktur (SWS) eine Pyramidenarray-Oberflächenreliefstruktur umfasst.

5. Mehrschichtspiegel nach einem der Ansprüche 1 bis 4, wobei eine Periodenlänge (P_{SWS}) der periodischen Subwellenlängenstruktur (SWS) größer als eine Wellenlänge in dem ersten Wellenlängenbereich und kleiner als eine Wellenlänge in dem zweiten Wellenlängenbereich ist.

6. Mehrschichtspiegel nach einem der Ansprüche 1 bis 5, wobei eine strukturelle Tiefe (SD_{SWS}) der Subwellenlängenstruktur (SWS) kleiner als die Wellenlänge in dem zweiten Wellenlängenbereich ist.

7. Mehrschichtspiegel nach einem der vorhergehenden Ansprüche, wobei die nicht beugende Antireflexionsschicht mit Brechungsindexgradienten aus einem einzigen Material, das eine niedrige Absorption aufweist, mit einem Extinktionskoeffizienten von weniger als 0,007 für EUV-Strahlung in dem ersten Wellenlängenbereich gebildet ist, wobei das einzige Material aus der Gruppe ausgewählt ist, die aus amorphem Silicium (Si), hydrogenisiertem Silicium α-Si:H und Kohlenstoff (C) besteht.

8. Mehrschichtspiegel nach einem der Ansprüche 1 bis 6, wobei die nicht beugende Antireflexionsschicht mit Brechungsindexgradienten eine Mehrschichtstruktur umfasst, die der Mehrschichtstruktur des Stapels aus Schichten entspricht.

9. Mehrschichtspiegel nach einem der vorhergehenden Ansprüche, wobei eine Schutzdeckschicht auf der nicht beugenden Antireflexionsschicht mit Brechungsindexgradienten gebildet ist.

10. Mehrschichtspiegel nach einem der vorhergehenden Ansprüche, wobei die nicht beugende Antireflexionsschicht mit Brechungsindexgradienten auf einer Beugungsgitterstruktur angeordnet ist, die zum Beugen von Strahlung eines dritten Wellenlängenbereichs mit Wellenlängen größer als die zweite Wellenlänge dimensioniert ist.

11. Mehrschichtspiegel nach einem der vorhergehenden Ansprüche, wobei der Mehrschichtspiegel ein Sammelspiegel (COL) zum Sammeln von EUV-Strahlung ist, die von einer EUV-Strahlungsquelle emittiert wird.

12. EUV-Optiksystem, das wenigstens einen Mehrschichtspiegel nach einem der Ansprüche 1 bis 11 umfasst.

## Revendications

1. Miroir à plusieurs couches (M) réfléchissant le rayonnement ultraviolet extrême (EUV - extreme ultraviolet) d'une première gamme de longueurs d'onde dans une région spectrale de l'EUV, le miroir comprenant :
un substrat (SUB) ;
un empilement de couches (SL - stack of layers) sur le substrat,
l'empilement de couches comprenant des couches contenant un matériau à faible indice et un matériau à indice élevé, le matériau à faible indice ayant une partie réelle de l'indice de réfraction inférieure à celle du matériau à indice élevé à une longueur d'onde de fonctionnement donnée λ dans la première plage de longueurs d'onde,
un filtre de pureté spectrale placé au-dessus de l'empilement de couches, le filtre de pureté spectrale étant efficace en tant que couche antireflet pour le rayonnement ultraviolet (UV) d'une seconde plage de longueurs d'onde dans une région spectrale UV afin d'augmenter le rapport de réflectivité EUV-UV du miroir à plusieurs couches,
**caractérisé en ce que**
le filtre de pureté spectrale (SPF - spectral purity filter) comprend une couche antireflet à indice progressif (GI-AR - graded-index anti-reflection) sans diffraction, efficace pour réduire la réflectivité dans la seconde plage de longueurs d'onde,
la couche antireflet à indice progressif sans diffraction (GI-AR) comprenant une structure de longueurs d'onde secondaires (SWS - sub-wavelength structure) comprenant des éléments structurels (SE - structural elements) ayant des dimensions latérales inférieures à la longueur d'onde UV dans la seconde plage de longueurs d'onde de telle sorte que la structure de longueurs d'onde secondaires (SWS) soit efficace pour le rayonnement ultraviolet dans la seconde gamme de longueurs d'onde en tant que milieu efficace à indice de réfraction progressif, capable de réduire le contraste optique au niveau d'une surface d'entrée du rayonnement de l'empilement de couches et supprimer au moins partiellement la réflexion du rayonnement ultraviolet,
dans lequel la structure de longueurs d'onde secondaires (SWS) est une structure périodique comprenant un ensemble d'éléments structurels effilés (SE) formant une structure périodique de décharge en surface, une longueur de la période (PSWS) de la structure périodique de longueurs d'onde secondaires (SWS) se situant dans une plage de 25 nm à 100 nm.

2. Miroir à plusieurs couches selon la revendication 1, dans lequel la structure de longueurs d'onde secondaires (SWS) est une structure comprenant un réseau d'éléments structurels (SE) ayant un indice de réfraction effectif variant de manière monotone dans la seconde plage de longueurs d'onde d'un côté du substrat à un côté de l'incidence du rayonnement.

3. Miroir à plusieurs couches selon la revendication 1 ou 2, dans lequel la structure de longueurs d'onde secondaires comprenant un réseau d'éléments structurels effilés formant une structure périodique de décharge en surface présente une seule périodicité sur toute la surface réfléchissante ou dans lequel la structure de longueurs d'onde secondaires est une structure périodique combinée dans laquelle deux ou plus de deux structures effilées de profil différent sont combinées sur l'ensemble de la surface réfléchissante.

4. Miroir à plusieurs couches selon l'une des revendications 1 à 3, dans lequel la structure de longueurs d'onde secondaires (SWS) comprend une structure de décharge en surface à réseau pyramidal.

5. Miroir à plusieurs couches selon l'une des revendications 1 à 4, dans lequel une longueur de période (P_{SWS}) de la structure périodique des longueurs d'onde secondaires (SWS) est supérieure à une longueur d'onde de la première plage de longueurs d'onde et inférieure à une longueur d'onde de la seconde plage de longueurs d'onde.

6. Miroir à plusieurs couches selon l'une des revendications 1 à 5, dans lequel une profondeur structurelle (SD_{SWS}) de la structure de longueurs d'onde secondaires (SWS) est inférieure à la longueur d'onde de la seconde plage de longueurs d'onde.

7. Miroir à plusieurs couches selon l'une quelconque des revendications précédentes, dans lequel la couche antireflet à indice progressif sans diffraction est réalisée en un matériau unique ayant une faible absorption et un coefficient d'extinction inférieur à 0,007 pour le rayonnement EUV de la première plage de longueurs d'onde, dans lequel le matériau unique est choisi dans le groupe constitué par du silicium amorphe (Si), du silicium hydrogéné α-Si:H et du carbone (C).

8. Miroir à plusieurs couches selon l'une quelconque des revendications 1 à 6, dans lequel la couche antireflet à indice progressif sans diffraction comprend une structure à plusieurs couches correspondant à la structure à plusieurs couches de l'empilement de couches.

9. Miroir à plusieurs couches selon l'une quelconque des revendications précédentes, dans lequel une couche de recouvrement protectrice est formée sur la couche antireflet à indice progressif sans diffraction.

10. Miroir à plusieurs couches selon l'une quelconque des revendications précédentes, dans lequel la couche antireflet à indice progressif sans diffraction est disposée sur une structure de réseau à diffraction dimensionnée pour diffracter le rayonnement à partir d'une troisième plage de longueurs d'onde ayant des longueurs d'onde supérieures à la seconde longueur d'onde.

11. Miroir à plusieurs couches selon l'une quelconque des revendications précédentes, le miroir à plusieurs couches étant un miroir collecteur (COL) pour collecter le rayonnement EUV émis par une source de rayonnement EUV.

12. Système optique EUV comprenant au moins un miroir à plusieurs couches selon l'une des revendications 1 à 11.
